Europäisches Patentamt

European Patent Office

Office européen des brevets

(11) Publication number: **0 292 116**
**A2**

## EUROPEAN PATENT APPLICATION

(21) Application number: 88303612.1

(22) Date of filing: 21.04.88

(51) Int. Cl.⁴ **G01R 31/28**

(30) Priority: 05.05.87 US 46218

(43) Date of publication of application:
**23.11.88 Bulletin 88/47**

(84) Designated Contracting States:
**DE FR GB**

(71) Applicant: **CONTROL DATA CORPORATION**
**8100-34th Avenue South**
**Minneapolis Minnesota 55440(US)**

(72) Inventor: **Stoica, Susana**
**5816 Creek Valley Road South**
**Edina Minnesota 55434(US)**

(74) Representative: **Caro, William Egerton et al**
**J. MILLER & CO. Lincoln House 296-302 High**
**Holborn**
**London WC1V 7JH(GB)**

(54) **Test system for vlsi circuits.**

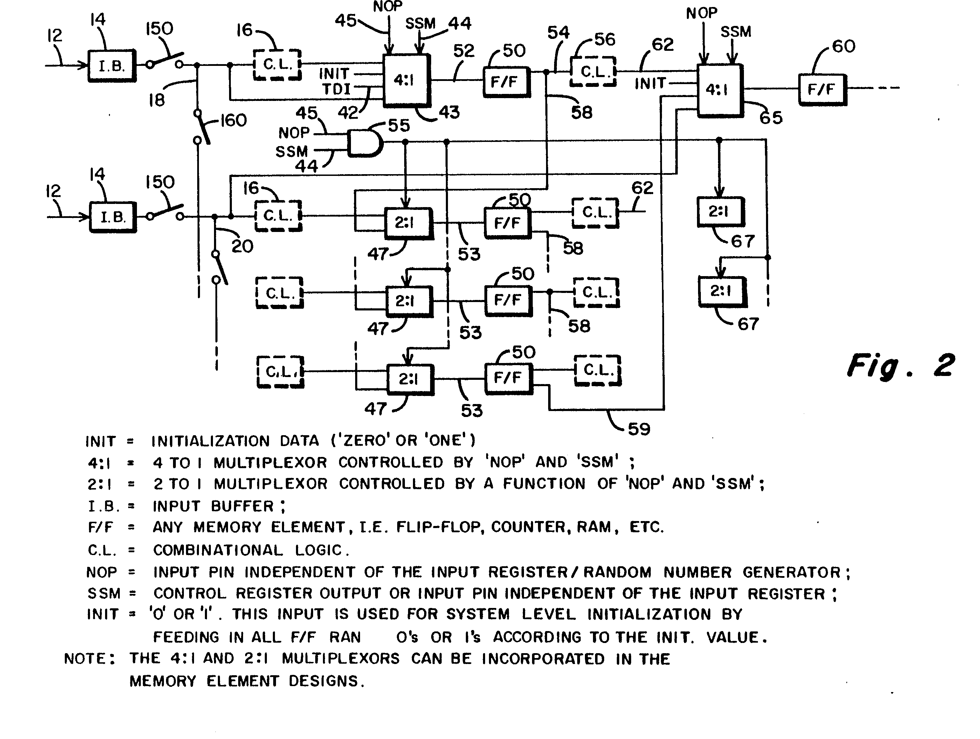

(57) An integrated circuit chip with an on-chip test
system has flip-flops arranged in ranks (50, 60,...,
90) and chains and interconnected by combinatorial
logic (56, 80, ..., 100), each flip-flop having a test
input fed directly from the preceding flip-flop (52, 58,
70, ...) bypassing the combinatorial logic and oper-
ative in the absence of a NOP (normal operation)
signal. Multiplexers (40) couple the end of each
chain to the beginning of the next. Each flip-flop acts
as an ordinary flip-flop preceded by a multiplexer.
An additional initialising input may be multiplexed
into the flip-flops (Figure 2). The test input couplings
may be non-linear, to prevent reconvergence of sig-
nals (Figures 2-5). To test the combinatorial logic
feeding a particular flip-flop, a test bit pattern may
be sequentially clocked into the flip-flops feeding
that piece of combinatorial logic with NOP = 0, NOP
set to 1 for one clock period, and the resulting bit
sequentially clocked out with NOP = 0 again.

Fig. 1A

Fig. 1B

# TEST SYSTEM FOR VLSI CIRCUITS

The present invention relates to VLSI (very large scale integration) circuit chips, as found for example in digital electronic systems.

A VLSI circuit chip having an on-chip maintenance system (OCMS), in which the flip-flops are arranged in ranks and chains and are specialised in that each can be caused to respond either to its normal input from combinatorial logic or to a test input from a preceding flip-flop which bypasses the combinatorial logic, is described in our earlier European Patent Application No 86307756.6 (EP-A-O 228 156). The present invention is generally to correct an error in the system described therein and to provide various improvements thereto.

According to one aspect, the present invention provides an integrated circuit chip comprising a plurality of flip-flops interconnected through combinatorial logic and fed from a set of input pins and feeding a set of output pins, and including an on chip maintenance test system (OCMS) having an input register coupled between the input pins and the flip-flops and an output register coupled between the flip-flops and the output pins, characterised in that at least some of the flip-flops are specialised flip-flops each of which has a test input (lower input) fed directly from a preceding flip-flop and bypassing the combinatorial logic and responds to the signal on the test input instead of the signal on the normal input from the combinatorial logic when a normal operation signal (NOP) is absent, the normal operation signals for all specialised flip-flops preferably being derived directly from a common pin.

Preferably the output register of the maintenance test system is multi-bit, the input register of the maintenance test system has a random number generating function, and there are switching means for feeding the flip-flops and combinatorial logic unit from the input pins or the input register.

Preferably the flip-flops are arranged in a plurality of chains, the output of the last specialised flip-flop in a chain being selectively connectable to the test input of the first specialised flip-flop in the next subsequent chain through a multiplexer and directly or through combinatorial logic to either an output pin or a bit of the output register. Preferably also in cases where the last flip-flop in a chain has an output through combinatorial logic, an additional multiplexer means selects whether the flip-flop output goes through the combinatorial logic to the output pin or the output register or whether the combinatorial logic is bypassed. Preferably there is also multiplexer means fed from an input pin and a test data input and feeding the first of the specialised flip-flops. There is also preferably a set of multiplexer means for all chains except the first, each of which is fed from the end of the preceding chain and the junctions between the input pins and the input register and feeds the test input of the first specialised flip-flop of its chain. At least some of the multiplexers may have a further input fed with an initialisation signal.

Preferably also the sequence of connections of the test inputs of the specialised flip-flops is randomised to prevent reconvergence.

According to another aspect, the present invention provides a method of testing a selected portion of combinatorial logic in an integrated circuit chip as defined above, characterised by setting the normal operation signal (NOP) to 0 band clocking test data in to the flip-flops until it reaches all the memory elements providing inputs to the selected portion of combinatorial logic, setting the normal operation signal (NOP) to 1 for one clock cycle, and returning the normal operation signal to 0 and continuing the clocking until the states of all flip-flops fed by the selected portion of combinatorial logic have been passed out of the chip.

Various testable circuits formed on large-scale integrated circuit chips and embodying various aspects of the invention will now be described, by way of example, with reference to the drawings, in which:

Figures 1A and 1B together are a block diagram of a testable circuit; and

Figures 2 to 5 are partial block diagrams of modifications of the circuit of Figures 1A and 1B.

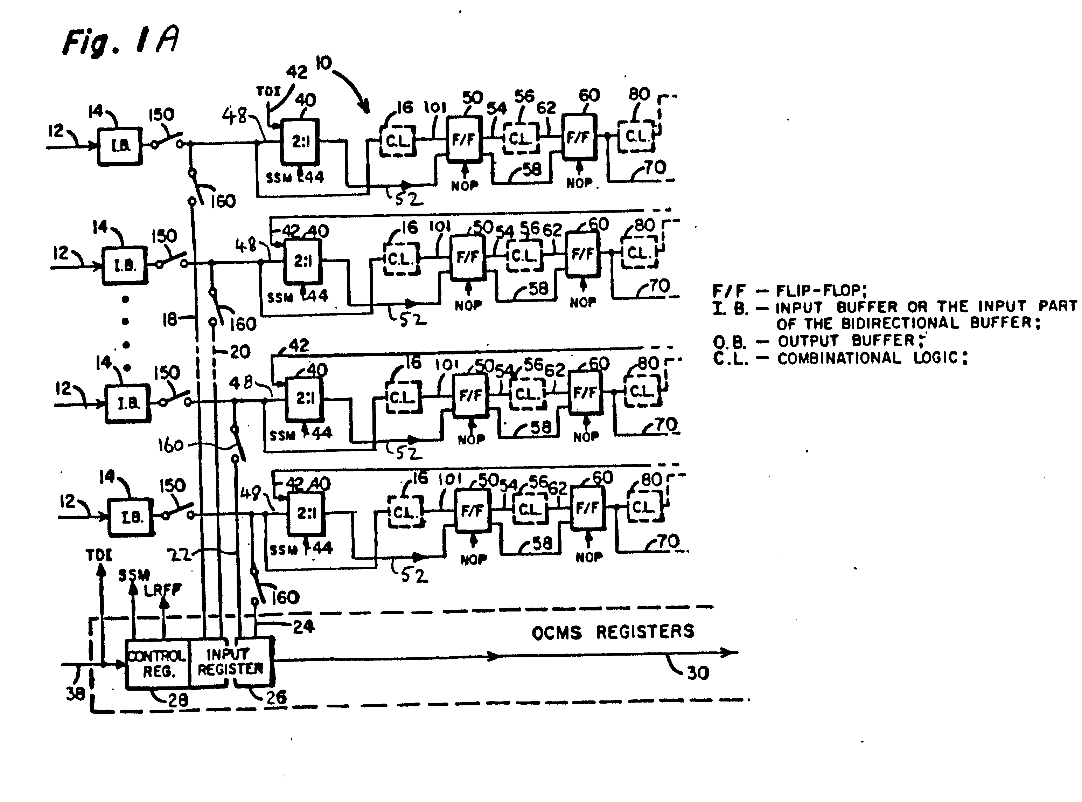

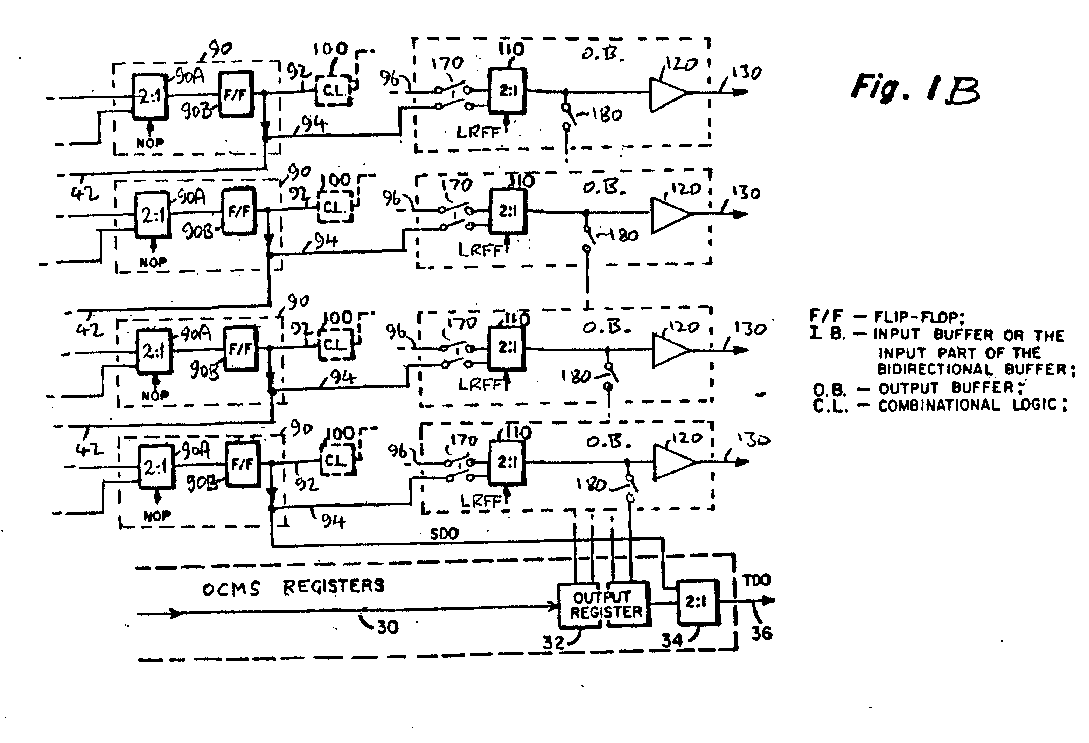

The circuit of Figure 1 is based closely on the circuit of Figure 1 of our earlier case mentioned above, but differs in a number of detailed respects. In order to understand the present circuit, it is desirable to review briefly that previous circuit.

The previous circuit consists of a large number of flip-flops interconnected by combinatorial logic circuits to perform some desired function. For testing purposes, certain additional circuitry is included, and the flip-flops individually include features which are arranged and interconnected in a manner which facilitate testing. The additional circuitry consists primarily of OCMS (on-chip maintenance system) registers (a control register 28, an input test register 26 including a pseudo-random number generator, and an output test register 32 including check sum means). The additional features of an individual flip-flop consist primarily of the addition of a test input and test output to the flip-flop, controlled by a NOP (normal operation) signal, such that the flip-flop responds to its normal (data) input when the NOP signal is 1, but to the test input when NOP is 0. The arrangement and interconnection of the flip-flops has three major features:

a) The flip-flops are arranged in a matrix of ranks 50, 60,..., 90 and chains, such that data passes from the flip-flops one rank to those of the next (or a still later) rank on each clock pulse, through the combinational logic circuits, and from one flip-flop to the next along each chain under NOP = 0 test conditions. The data inputs 12 to the circuit as a whole are connected via an input buffer 14 to the first flip-flops in the chains, i.e. generally to the first rank 50 of flip-flops, and the data outputs from the circuit as a whole are connected from the last flip-flops in the chains, i.e. generally from the last rank 90 of flip-flops, to an output buffer 120.

b) The test input and output registers 26 and 32 are similarly connected to the first and last ranks of the flip-flops, and these connections and those of the input and output buffers include switches 150, 160, 170, and 180 to control the flow of data or test signals.

c) Multiplexers 40 and 110 are provided at the ends of the chains of flip-flops to select between data and test signals, and to permit the looping back of test signals from the end of each chain to the beginning of the next.

A number of modes of operation of this circuitry are described in the earlier case. There is standard operation (logic analyser sequence), in which the circuitry performs its normal operation (designed function), which may be monitored by the OCMS (which monitors the signals entering the flip-flops and combinatorial logic circuitry from the input buffer and those leaving that circuitry for the output buffer). There is a basic chip interconnect test sequence, in which the signals are passed from the input to the output buffer via the OCMS, bypassing the flip-flop and combinatorial logic circuitry. There are static and dynamic general chip test modes in which signals are passed through the flip-flop and combinatorial logic circuitry via the OCMS, bypassing the input and output buffers. There are combinatorial logic test modes, like the general chip test modes but in which all the combinatorial logic is bypassed except that between two particular adjacent ranks (or between the input buffer and the first rank, or the last rank and the output buffer). There are flip-flop forcing modes in which all the combinatorial logic coupling the flip-flops is bypassed, so that the flip-flops can be forced to predetermined values, from the input buffer or the OCMS, in each chain, and the outputs of the chains monitored by the OCMS. Finally, there is a serial scan mode, in which all the combinatorial logic is bypassed and the chains are all connected in sequence to form a single test path through all flip-flops.

Referring to Figures 1A and 1B, three ranks of flip-flops are shown; rank 50 is the first rank, rank 60 is the second rank, and rank 90 is the last rank. There may of course be further ranks between ranks 60 and 90, as indicated. Four chains of these flip-flops are shown, the first two and the last two; there may of course be further chains between the second and third of these, as indicated. The first rank 50 is fed from an input buffer 14, and the last rank 90 feeds an output buffer 120. There are ranks of combinatorial logic 16, 56, 80, ..., 100 between the input buffer and the first rank of flip-flops, successive ranks of flip-flops, and the last rank of flip-flops and the output buffer, as shown.

Each of the flip-flops is a specialised flip-flop having a normal (data) input and output (shown on the centre horizontal line of the flip-flop) and a test input and output (shown below the centre horizontal line of the flip-flop), and an NOP control input; the flip-flop normally responds to the data input (signal NOP = 1), but when the signal at the NOP input is 0, the flip-flop responds to the test input. The data inputs and outputs are connected to the combinatorial logic; the test outputs from each flip-flop is coupled directly to the test input of the next flip-flop in the same chain, by lines 58, ..., 70 as shown, bypassing the combinatorial logic between the flip-flops.

There is an OCMS consisting primarily of a control register 28, an input test register 26, and an output test register 30, as shown. The input test register 26 is coupled to the chains of flip-flops through a set of switches 160, and the input buffer 14 is similarly coupled to the chains of flip-flops through a set of switches 150, as shown. The ends of the chains of switches are coupled through a set of switches 170 to the output buffer 120, and through a further set of switches 180 to the output test register 32, as shown.

At the beginning of each chain of flip-flops, the input buffer 14 and the input test register 26 are coupled through the switches 150 and 160 to a set of lines 48, which are connected through the rank of combinatorial logic 16 to the data input of the first flip-flop of each chain (rank 50), and also to a set of 2:1 multiplexers 40, which feed the test inputs of these flip-flops, as shown. At the end of each chain, there is a multiplexer 110, which is fed from the test output of the last flip-flop of the chain (rank 90), and also by the output of the last rank of combinatorial logic of the chain (rank 100). The test output of the last flip-flop of each chain (rank 90) also feeds back to the multiplexer 40 of the next chain down, as shown. (The multiplexer 40 of the first chain has its second input fed with the test data input signal TDI as shown, and the test output of the last flip-flop of the last chain feeds a serial data out signal SDO to the OCMS, as shown.)

For the serial scan mode, the signal NOP is set to 0, so that all flip-flops respond to the test inputs, thus bypassing the combinatorial logic. A serial signal fed in as signal TDI is fed to the first flip-flop of the first chain, and passes serially along the chain on successive clock pulses. The serial scan mode signal SSM is also set to 1 for the serial scan mode. At the end of the first chain, the signal passes back along line 42 to the start of the second chain, and is selected by the multiplexer 40 by the signal SSM to enter that chain. The signal thus passes along that chain, then from the end of that chain to the start of the third (where the signal on line 42 is again selected by the multiplexer 40 because SSM = 1), and so on until it reached the end of the last chain as signal SDO.

The serial scan mode can thus be used to check the performance of the flip-flops. More generally, however, the serial scan mode can be entered and/or left at any convenient time. Thus data can be passed through the chip in normal operation (NOP = 1), and the serial scan mode then entered to read out serially the states of all flip-flops, so obtaining a snap-shot of the state of the chip. Also, the flip-flops can be set to a particular combination of states using the serial scan mode, normal operation resumed for a single clock period, and the serial scan mode then being re-entered to read out the states of the flip-flops; this enables the results of the operation of each block of the combinatorial logic to be examined independently.

In the circuit shown in the previous case, each multiplexer 40 was connected in line 101 (instead of between lines 48 and 52), and each line 48 was connected directly to the test input of the flip-flop of rank 50 as well as to the combinatorial logic 16. With those connections, the serial scan mode did not operate correctly, because with NOP = 0, the flip-flops 50 responded to their test inputs, which were fed from the input buffer 14. Those connections thus failed to produce a continuous scan chain through the logic. The circuit of the previous case did however work in all essential modes as drawn and described in that case. Serial scan mode is a feature which designers of LSI or VLSI circuits like to have, but it was not an essential feature of the invention, nor is it claimed in the earlier case. The minor rerouting of the input lines to the first rank of flip-flops, as shown in Figure 1A, corrects the problem.

Figure 1A also shows, at flip-flop rank 60, a slight variation in flip-flop structure on the output of the flip-flops, where there is only one output line, on which both the normal (data) output and the test output appear. In other words, the output from each specialised flip-flop may be unitary and sent over two leads instead of having two leads emerge from the flip-flop as shown in earlier Figures. (In the case where there are two outputs the signal would be identical anyway.) All flip-flops could be constructed similarly to those of rank 60.

In Figure 1B, the flip-flops in rank 90 are shown to be expanded into two elements, a multiplexer 90A, whose normal operation input is the operational input to the multiplexer, and 90B, which operates as a normal flip-flop. This merely illustrates the fact that the flip-flop as shown operates as if it were these two logical elements, and could be built as such. Note that the output lines 92 and 94 could also have been provided as two separate lines from flip-flop 90B.

Figure 1B also shows an output buffer, of slightly different form from that of the earlier case, which resides at a physical location distant from the ranks of flip-flops and combinational logic elements. In large-scale integrated circuit design, it may be useful to have the output buffer located on the periphery of the chip. In order to gain even further savings in space utilisation on the chip, putting the switches and the multiplexers which are connected to the output buffers on the chip periphery would also be useful. This saves useful space at the interior of the chip for more logic gates and greater flexibility in chip design and functionality. Each switch 170 is shown as a double switch on the input side of the multiplexer 110; alternatively, it may be a single switch on the output side, as in the earlier case. (It will be realised that the multiplexers 110 are analogous to the multiplexers 90A of the flip-flops of rank 90; the multiplexers 40, however, serve a slightly different purpose, concerned with looping back the serial scan path from one chain to the next.)

Figure 2 shows a variation of the Figures 1A and 1B layout. This uses a 4:1 multiplexer in place of the multiplexer 40, with one of the inputs being an initialisation signal INIT, which may be tied to 0 or 1 as desired by the designer. The flip-flops may be controlled by a combination of the signals NOP and SSM produced by a gate 55. (Note that the flip-flops are shown expanded into simple flip-flops and 2:1 multiplexers, as shown for flip-flop 90 in Figure 1B.) Alternatively, some or all of the flip-flops may also include 4:1 multiplexers, as shown for flip-flop 60, which also have an INIT input, in place of the 2:1 multiplexers shown in Figure 1B.

This arrangement allows for the initialisation of the flip-flop ranks using the signal INIT value defined by the designer and fed through the 4:1 multiplexers. The signal INIT (0 or 1) is shifted through the flip-flops in a given rank (rank 50, for example), with the help of the 2:1 multiplexers which can select the test output from a flip-flop to go into the test input of the next one, under the control of the function of NOP and SSM signal inputs generated by gate 55. The 2:1 multiplexers 47 and 67 operate as the front end to the associated flip-flops, just as in Figure 1B (90A and 90B). Thus the chains of flip-flops may be initialised to 1 or 0 through the line INIT.

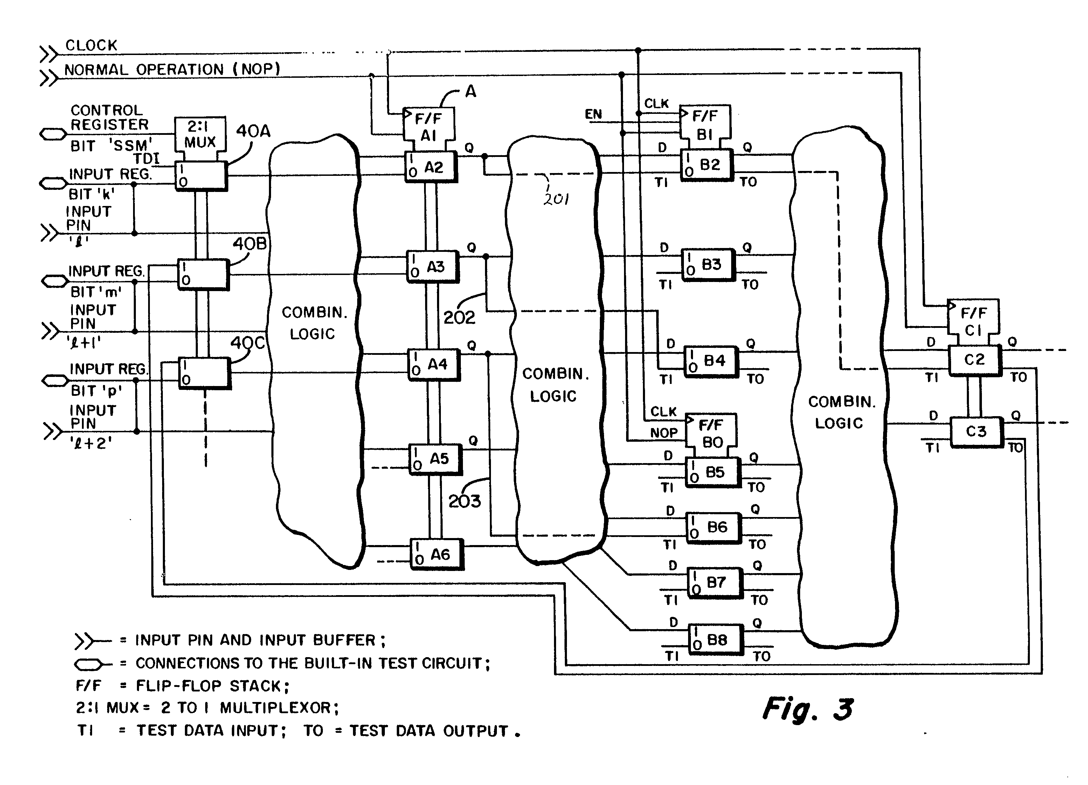

Figure 3 shows an abridged set of flip-flop ranks as they might be laid out on a chip, comprised of cells (for example A1 - A6 would be a row of configurable cells, with A1 configured to be a control hat and A2 -A6 being specialised flip-flops). It is not a requirement that all chains have the same length. T1 indicates test input lines, D indicates normal or operational data input lines, T0 indicates test output lines, and Q indicates normal output lines (T0 and Q may be one and the same line).

If the organisation of test signal lines is similar to that shown in Figures 1A and 1B, the test output from element A2 would lead to the test input of element B2 (line 201), and similarly for A3 to B4 (line 202). However, it may be desirable for the test signal lines may go to different flip-flops, to randomised the test data and thereby avoid reconvergence problems. In Figure 3, the dotted line 202 shows such an out-of-sequence test data connection used to avoid reconvergence.

For purposes of randomising the input test operands, one could introduce extra gates, inverters, and other devices, but the most efficient use of chip space would seem to be non-linear passing through of the test data lines between ranks of flip-flops. It should be recalled that the input register has pseudo-random number generating capabilities and is directed by the control register.

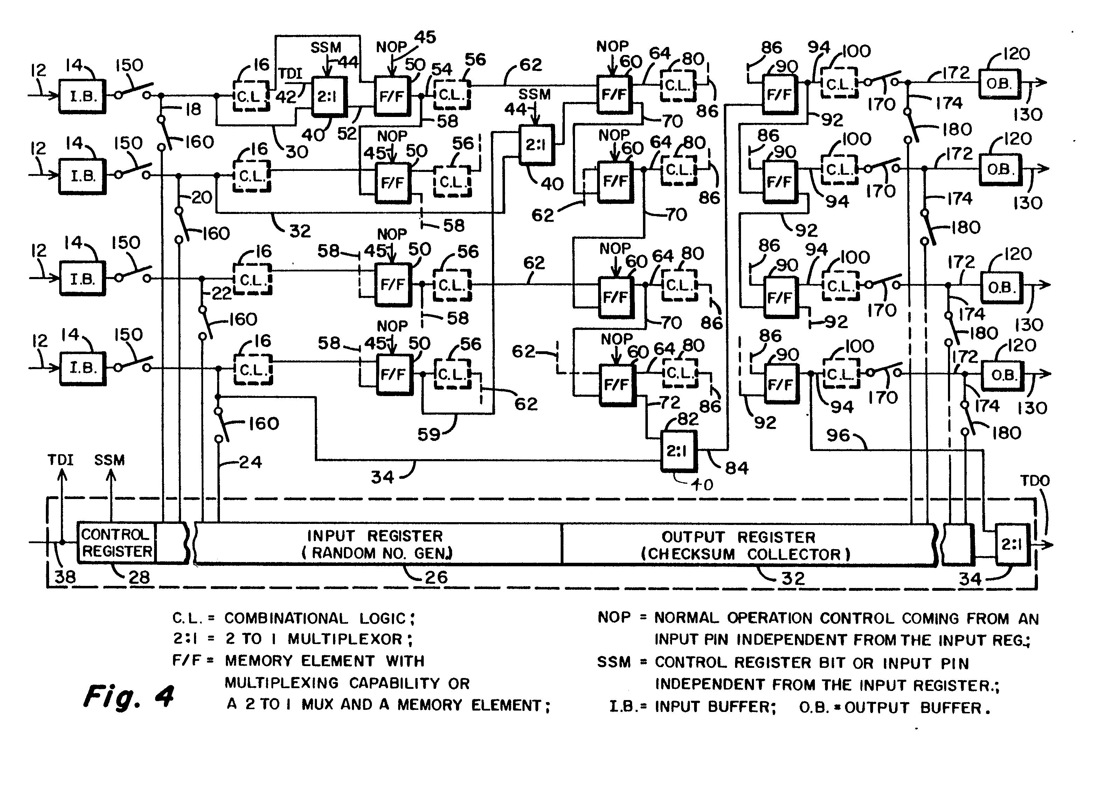

Figure 3 shows a reorganisation of the test inputs and outputs which corresponds generally to the organisation shown in Figure 4. Note that to enhance randomisation of test operands at stages in the flow from input to output, not all the outputs from the input buffer 14 or the built-in test input register/random number generator 26 are provided in sequence to the 2:1 multiplexers 40.

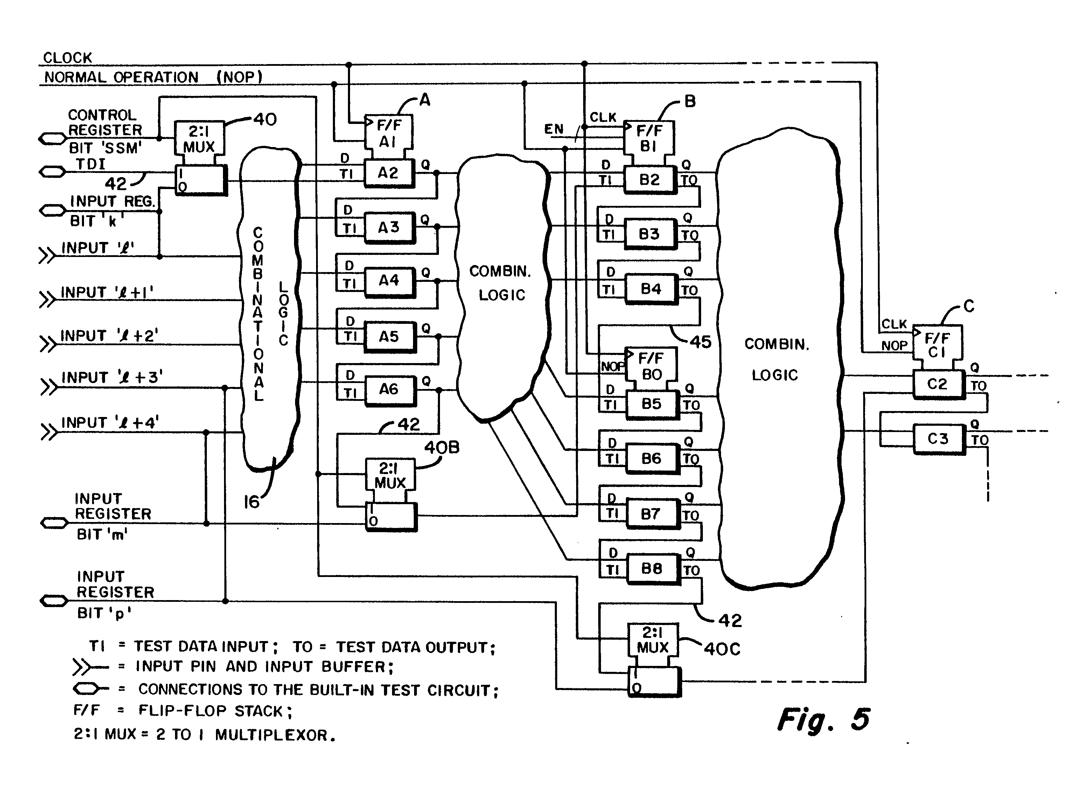

Figure 5 is a modified version of Figure 3 with the general organisation shown in Figure 4. Where the first flip-flop is at the top of a column of cells such as the element labelled A2, the test input is the output of the 2:1 multiplexer, but the test inputs to and outputs from the succeeding elements of a column are simply routed to adjacent elements, until the last element in a column is reached. Then the test data path goes to the first flip-flop element in another column (45), or to the first line 42 in the 2:1 multiplexer if the end of a chain of flip-flops is reached. This organisation of the test data lines is similar to that found in Figures 2 and 4.

Several further features are applicable to all the arrangements described.

One or more of signals NOP, SSM, and LRFF may be provided via independent input pins to the chip instead of from the control and input registers as shown.

In any location where a flip-flop is shown, any clocked memory element could be used which could perform the same function. For example, in a counter or RAM element, 2:1 multiplexers could choose the test data or normal data input for the memory elements.

A limited number of specialised flip-flops may be used, if desired, to test only particular areas of the logic. Some memory elements or flip-flops may exist in the chip which are not part of the test structure, of course, or all of them may be part of the test structure. In normal operation, flip-flops are connected to the next flip-flop rank through combinational logic but they may also during normal operation be directly connected, if no combinational logic is required between the two flip-flop ranks.

## Claims

1. An integrated circuit chip comprising a plurality of flip-flops (50, 60,..., 90) interconnected through combinatorial logic (16, 56, 80, ...,100) and fed from a set of input pins (12) and feeding a set of output pins (130), and including an on chip maintenance test system (OCMS) having an input register (26) coupled between the input pins and the flip flips and an output register (32) coupled between the flip-flops and the output pins, characterised in that at least some of the flip-flops are specialised flip-flops each of which has a test input (lower input) fed directly from a preceding flip-flop and bypassing the combinatorial logic and responds to the signal on the test input instead of the signal on the normal input from the combinatorial logic when a normal operation signal (NOP) is absent.

2. An integrated circuit chip according to claim 1, characterised in that the output register (32) of the maintenance test system is multi-bit.

3. An integrated circuit chip according to either previous claim, characterised in that the input register (26) of the maintenance test system has a random number generating function.

4. An integrated circuit chip according to any previous claim, characterised by switching means (150, 160) for feeding the flip-flops and combinatorial logic unit from the input pins or the input register.

5. An integrated circuit chip according to any previous claim characterised in that the normal operation signals for all specialised flip-flops are derived directly from a common pin.

6. An integrated circuit chip according to any previous claim wherein the flip-flops are arranged in a plurality of chains, characterised in that the output of the last specialised flip-flop in a chain is selectively connectable to the test input of the first specialised flip-flop in the next subsequent chain through a multiplexer (40) and directly or through combinatorial logic to either an output pin or a bit of the output register.

7. An integrated circuit chip according to claim 6, characterised in that in cases where the last flip-flop in a chain has an output through combinatorial logic, an additional multiplexer means (110) selects whether the flip-flop output goes through the combinatorial logic to the output pin or the output register or whether the combinatorial logic is bypassed.

8. An integrated circuit chip according to either of claims 6 and 7, characterised by multiplexer means (40, top chain) fed from an input pin and a test data input and feeding the first of the specialised flip-flops.

9. An integrated circuit chip according to any of claims 6 to 8, characterised by a set of multiplexer means (40) for all chains except the first, each of which is fed from the end of the preceding chain and the junctions between the input pins and the input register (26) and feeds the test input of the first specialised flip-flop of its chain.

10. An integrated circuit chip according to any of claims 6 to 9, characterised in that at least some of the multiplexers (43, 55) have a further input fed with an initialisation signal (INIT).

11. An integrated circuit chip according to any of claims 6 to 10, characterised in that the sequence of connections of the test inputs of the specialised flip flips is randomised to prevent reconvergence (Figures 2-5).

12. A method of testing a selected portion of combinatorial logic in an integrated circuit chip according to any previous claim, characterised by setting the normal operation signal (NOP) to 0 and clocking test data in to the flip-flops until it reaches all the memory elements providing inputs to the selected portion of combinatorial logic, setting the normal operation signal (NOP) to 1 for one clock cycle, and returning the normal operation signal to 0 and continuing the clocking until the states of all flip-flops fed by the selected portion of combinatorial logic have been passed out of the chip.

Fig. IA

F/F — FLIP-FLOP;
I. B. — INPUT BUFFER OR THE INPUT PART OF THE BIDIRECTIONAL BUFFER;
O.B. — OUTPUT BUFFER;
C.L. — COMBINATIONAL LOGIC;

OCMS REGISTERS

Fig. 1B

F/F — FLIP-FLOP;
I.B. — INPUT BUFFER OR THE
INPUT PART OF THE
BIDIRECTIONAL BUFFER;
O.B. — OUTPUT BUFFER;
C.L. — COMBINATIONAL LOGIC;

Fig. 2

INIT = INITIALIZATION DATA ('ZERO' OR 'ONE')

4:1 = 4 TO 1 MULTIPLEXOR CONTROLLED BY 'NOP' AND 'SSM' ;

2:1 = 2 TO 1 MULTIPLEXOR CONTROLLED BY A FUNCTION OF 'NOP' AND 'SSM' ;

I.B. = INPUT BUFFER ;

F/F = ANY MEMORY ELEMENT, I.E. FLIP-FLOP, COUNTER, RAM, ETC.

C.L. = COMBINATIONAL LOGIC.

NOP = INPUT PIN INDEPENDENT OF THE INPUT REGISTER / RANDOM NUMBER GENERATOR ;

SSM = CONTROL REGISTER OUTPUT OR INPUT PIN INDEPENDENT OF THE INPUT REGISTER ;

INIT = '0' OR '1'. THIS INPUT IS USED FOR SYSTEM LEVEL INITIALIZATION BY
FEEDING IN ALL F/F RAN  0's OR 1's ACCORDING TO THE INIT. VALUE.

NOTE: THE 4:1 AND 2:1 MULTIPLEXORS CAN BE INCORPORATED IN THE
MEMORY ELEMENT DESIGNS.

CLOCK

NORMAL OPERATION (NOP)

CONTROL REGISTER BIT 'SSM' — 2:1 MUX 40A — TDI

INPUT REG. BIT 'k' INPUT PIN '$\ell$'

INPUT REG. BIT 'm' INPUT PIN '$\ell+1$' — 40B

INPUT REG. BIT 'p' INPUT PIN '$\ell+2$' — 40C

COMBIN. LOGIC

F/F A1 — A

A2 Q
A3 Q — 202
A4 Q
A5 Q — 203
A6

COMBIN. LOGIC — 201

COMBIN. LOGIC

EN — CLK — F/F B1
D — B2 — Q
TI — TO

D — B3 — Q
TI — TO

D — B4 — Q
TI — TO

CLK — F/F BO
NOP
D — B5 — Q
TI — TO

D — B6 — Q
TI — TO

D — B7 — Q
TI — TO

D — B8 — Q
TI — TO

COMBIN. LOGIC

F/F C1
D — C2 — Q
TI — TO

D — C3 — Q
TI — TO

0 292 116

$\gg$— = INPUT PIN AND INPUT BUFFER;

$\bigcirc$— = CONNECTIONS TO THE BUILT-IN TEST CIRCUIT;

F/F = FLIP-FLOP STACK;

2:1 MUX = 2 TO 1 MULTIPLEXOR;

TI = TEST DATA INPUT; TO = TEST DATA OUTPUT.

*Fig. 3*

Fig. 4

C.L. = COMBINATIONAL LOGIC;
2:1 = 2 TO I MULTIPLEXOR;
F/F = MEMORY ELEMENT WITH
MULTIPLEXING CAPABILITY OR
A 2 TO I MUX AND A MEMORY ELEMENT;

NOP = NORMAL OPERATION CONTROL COMING FROM AN
INPUT PIN INDEPENDENT FROM THE INPUT REG.;
SSM = CONTROL REGISTER BIT OR INPUT PIN
INDEPENDENT FROM THE INPUT REGISTER.;
I.B.= INPUT BUFFER;  O.B. = OUTPUT BUFFER.

0 292 116

Fig. 5

TI = TEST DATA INPUT; TO = TEST DATA OUTPUT;
>>— = INPUT PIN AND INPUT BUFFER;
⬭— = CONNECTIONS TO THE BUILT-IN TEST CIRCUIT;
F/F = FLIP-FLOP STACK;
2:1 MUX = 2 TO 1 MULTIPLEXOR.

0 292 116